# EUROPÄISCHE PATENTANMELDUNG

(11) **EP 4 628 805 A1**
(43) Veröffentlichungstag der Anmeldung: **08.10.2025**
(21) Anmeldenummer: 25167886.8
(22) Anmeldetag: 02.04.2025
(51) Int. Cl.: F24F 3/163, B08B 15/02, B25H 1/20, F24F 9/00, H01L 21/67

(54) **ARBEITSSTATIONSEINHAUSUNG ZUR BEARBEITUNG VON WERKSTÜCKEN IN EINER SEPARIERTEN UMGEBUNG UND VERFAHREN ZUM BETREIBEN DER ARBEITSSTATIONSEINHAUSUNG**

(30) Priorität: 04.04.2024 DE 102024109500
(71) Anmelder: thyssenkrupp Automation Engineering GmbH, 28777 Bremen (DE); thyssenkrupp AG, 45143 Essen (DE)
(72) Erfinder: Buchert, Jens, 09130 Chemnitz (DE); Kircheis, Timo, 08056 Zwickau (DE)
(74) Vertreter: thyssenkrupp Intellectual Property GmbH

(57) **Zusammenfassung**

Die vorliegende Erfindung betrifft eine Arbeitsstationseinhausung (1) zur Bearbeitung von Werkstücken in einer räumlich separierten Umgebung, wobei die Arbeitsstationseinhausung (1) eine Prozessebene (2) mit einer Einbringöffnung (6) zum Einbringen von zu bearbeitenden Werkstücken und eine Ausbringöffnung (7) zum Ausbringen von bearbeiteten Werkstücken umfasst. Die Arbeitsstationseinhausung (1) umfasst oberhalb der Prozessebene (2) eine Installationsebene (3), die durch eine Abtrennung (8) räumlich von der Prozessebene (2) getrennt ist, wobei die Installationsebene (3) für einen einstellbaren Lufttransfer zwischen der Installationsebene (3) und der Prozessebene (2) ein Umluftsystem (9) aufweist, und wobei das Umluftsystem (9) derart einstellbar ist, dass in der Prozessebene (2) ein Druckgefälle gegenüber einer äußeren Umgebung (5) der Arbeitsstationseinhausung (1) aufrecht erhalten werden kann. Vorteilhafterweise wird so ein Betrieb der Arbeitsstationseinhausung (1) in einer Reinraumumgebung (5) ermöglicht.

Ferner betrifft die Erfindung ein Verfahren zum Betreiben einer solchen Arbeitsstationseinhausung (1).

## Beschreibung

Die Erfindung betrifft eine Arbeitsstationseinhausung zur Bearbeitung von Werkstücken in einer separierten Umgebung, wobei die Arbeitsstationseinhausung eine Prozessebene mit einer Einbringöffnung zum Einbringen von zu bearbeitenden Werkstücken und eine Ausbringöffnung zum Ausbringen von bearbeiteten Werkstücken umfasst, wobei die Ausbringöffnung insbesondere an einem der Einbringöffnung gegenüberliegenden Ende der Prozessebene angeordnet ist. Des Weiteren betrifft die Erfindung ein Verfahren zum Betreiben einer Arbeitsstationseinhausung.

Zumindest für einzelne Werkzeuge beziehungsweise für einzelne Maschinen sind solche Arbeitsstationseinhausung als Maschineneinhausungen bekannt, wobei dann regelmäßig die Prozessebene die gesamte Maschineneinhausung bildet. Im Stand der Technik ist darüber hinaus, beispielsweise aus der WO 2013/127979 A1, eine Anlage zur Belüftung von Reinräumen mit mindestens zwei Reinräumen und einem Plenum oberhalb dieser Reinräume bekannt, wobei die Reinräume und das Plenum durch eine tragende Decke getrennt sind. Das Plenum ist dabei ein abgeschlossener Raum mit Umluftgeräten, der eine Eintrittsöffnung für primäre Luft und eine Austrittsöffnung für abgehende Luft aufweist.

Neben weiteren Anwendungsgebieten, wie der Herstellung von Leiterplatten oder Halbleiterchips, erfolgt auch die Batteriemodulherstellung für batterieelektrisch betriebene Kraftfahrzeuge in der Regel vollautomatisch innerhalb von Arbeitsstationseinhausungen, insbesondere in Maschineneinhausungen, die in Sauberzonen oder Sauberräumen arrangiert sind. Grundbausteine der Batteriemodule sind die eigentlichen Batteriezellen. Diese können beispielsweise als Pouchzelle, prismatische Hardcase-Zelle oder Rundzelle ausgebildet sein. Unabhängig von der strukturellen Gestaltung des Zellkörpers bedingt deren Herstellung mitunter eine Reinraumumgebung, so beispielsweise das Befüllen mit Elektrolyt sowie das anschließende Verschließen des Zellkörpers.

Hiervon ausgehend ist es eine Aufgabe der vorliegenden Erfindung, für eine vollautomatische Durchführbarkeit vorstehend beschriebener Prozesse eine Arbeitsstationseinhausung, die in einer Reinraumumgebung betrieben werden kann, und ein entsprechendes Verfahren zum Betreiben der Arbeitsstationseinhausung bereitzustellen, wobei insbesondere sichergestellt wird, dass der Reinraum dabei durch die in der Arbeitsstationseinhausung erfolgenden Bearbeitungsschritte nicht mit Partikeln kontaminiert wird.

Zur Lösung dieser Aufgabe werden eine Arbeitsstationseinhausung gemäß Anspruch 1 und ein Verfahren zum Betreiben einer Arbeitsstationseinhausung gemäß dem nebengeordneten Anspruch vorgeschlagen. Weitere vorteilhafte Ausgestaltungen der Erfindung sind in den abhängigen Ansprüchen und der Beschreibung beschrieben sowie in den Figuren dargestellt.

Die vorgeschlagene Lösung sieht eine Arbeitsstationseinhausung zur Bearbeitung von Werkstücken, insbesondere von Batteriezellen für Fahrzeugbatteriemodule, in einer räumlich separierten Umgebung, insbesondere in einer gegenüber einer äußeren Umgebung der Arbeitsstationseinhausung räumlich separierten Umgebung, weiter insbesondere in einer gegenüber einer äußeren Reinraumumgebung der Arbeitsstationseinhausung räumlich separierten Umgebung vor. Die äußere Umgebung der Arbeitsstationseinhausung ist insbesondere eine geschlossene Umgebung, insbesondere ein Reinraum. Die Arbeitsstationseinhausung umfasst eine Prozessebene mit einer Einbringöffnung zum Einbringen von zu bearbeitenden Werkstücken in die Arbeitsstationseinhausung und eine Ausbringöffnung zum Ausbringen von bearbeiteten Werkstücken aus der Arbeitsstationseinhausung, wobei die Ausbringöffnung insbesondere an einem der Einbringöffnung gegenüberliegenden Ende der Prozessebene angeordnet ist. Insbesondere sind die Einbringöffnung und die Ausbringöffnung an den Stirnseiten der Arbeitsstationseinhausung angeordnet. Die Prozessebene ist vorteilhafterweise innerhalb der Arbeitsstationseinhausung ein erster von wenigstens zwei Teilbereichen der Arbeitsstationseinhausung. In der Prozessebene erfolgt vorteilhafterweise die Bearbeitung der Werkstücke. Insbesondere ist durch die Prozessebene durchführend ein Transportsystem, insbesondere eine Friktionsrollenkette, vorgesehen, über das Werkstückträger über die Einbringöffnung in die Prozessebene eingebracht werden können und über die Ausbringöffnung aus der Prozessebene ausgebracht werden können. Vorteilhafterweise ist so ein unterbrechungsfreier Materialtransport ermöglicht.

Oberhalb der Prozessebene umfasst die Arbeitsstationseinhausung eine Installationsebene, insbesondere ein Plenum, die durch eine Abtrennung räumlich von der Prozessebene getrennt ist. Die Installationsebene weist dabei ein Umluftsystem auf, das für einen einstellbaren Lufttransfer zwischen der Installationsebene und der Prozessebene ausgebildet ist, wobei das Umluftsystem derart einstellbar ist, dass in der Prozessebene ein Druckgefälle, insbesondere ein positives Druckgefälle oder ein negatives Druckgefälle, also insbesondere ein Druckunterschied, gegenüber einer Umgebung der Arbeitsstationseinhausung aufrechterhalten werden kann. Es besteht somit vorteilhafterweise die Möglichkeit, die im Inneren der Arbeitsstationseinhausung stattfindenden Prozesse im Überdruck oder im Unterdruck betreiben zu können, wobei bei einer Nutzung der Arbeitsstationseinhausung in einer Reinraumumgebung vorteilhafterweise ein Unterdruckbetrieb vorgesehen ist.

Um eine unzulässige Kontamination eines Reinraums bei einer Nutzung der Arbeitsstationseinhausung in einer Reinraumumgebung zu verhindern, insbesondere im Falle einer Freisetzung luftgetragener Partikel infolge eines in der Prozessebene der Arbeitsstationseinhausung stattfindenden Prozesses, ist die Arbeitsstationseinhausung also vorteilhafterweise ausgebildet, ein Druckgefälle ausgehend vom umgebenden Reinraum in Bezug auf den Prozessraum in der Prozessebene im Inneren der Arbeitsstationseinhausung auszubilden und aufrecht zu erhalten.

Findet in der Prozessebene der Arbeitsstationseinhausung ein sauberkeitskritischer Prozess statt, und ist der Aufstellort, also die äußere Umgebung der Arbeitsstationseinhausung, selbst hinsichtlich einer Partikelreinheit eine ungünstigere Umgebung als der von der Prozessebene umschlossene Innenraum der Arbeitsstationseinhausung, kann die Prozessebene der Arbeitsstationseinhausung vorteilhafterweise durch einfache Anpassungen betreffend den Betrieb des Umluftsystems auch mit Überdruck beaufschlagt werden, und die Überdruckkaskade ausgehend von der Arbeitsstationseinhausung beziehungsweise der Prozessebene der Arbeitsstationseinhausung aufgebaut werden.

Die Einbringöffnung und die Ausbringöffnung der Arbeitsstationseinhausung können insbesondere jeweils mit einer Schleuseneinheit, die insbesondere ein Schott umfassen kann, versehen sein. Dabei würde dann ein Werkstückträger mit einem zu bearbeitenden Werkstück über die der Einbringöffnung zugeordnete Schleuseneinheit in die Prozessebene eingeschleust und der Werkstückträger mit dem bearbeiteten Werkstück über die der Ausbringöffnung zugeordnete Schleuseneinheit aus der Prozessebene ausgeschleust. Vorteilhafterweise kann so das Druckgefälle weitestgehend ungestört aufrechterhalten werden. Zudem lassen sich mit einer solchen Schleusentechnik hohe Anforderungen an die Reinraumgüte erfüllen.

Gemäß einer besonders vorteilhaften Ausgestaltung ist der Einbringöffnung und der Ausbringöffnung jeweils eine Luftbarriere zugeordnet, die vorteilhafterweise anstelle einer Schleuseneinheit einerseits das Aufrechterhalten des Druckgefälles zwischen der Prozessebene und der äußeren Umgebung der Arbeitsstationseinhausung erlaubt und darüber hinaus vorteilhafterweise einen unterbrechungsfreien Materialtransport in und aus der Prozessebene erlaubt. Die jeweilige Luftbarriere trennt dabei vorteilhafterweise die Luftvolumina innerhalb der Prozessebene der Arbeitsstationseinhausung und außerhalb der Arbeitsstationseinhausung durch eine gezielte Strömungsbildung. Weiter vorteilhaft werden die Luftbarrieren jeweils durch ein an der jeweiligen Öffnung angeordnetes Luftmesser ausgebildet, insbesondere ein im oberhalb der jeweiligen Öffnung angeordnetes Luftmesser. Durch eine Anordnung des jeweiligen Luftmessers oberhalb der jeweiligen Öffnung und die daraus resultierende Ausrichtung der Luftbarriere von oben nach unten werden vorteilhafterweise möglicherweise vorhandene Partikelteile in der Nähe der Luftbarrieren in Bodennähe verbracht. Die Luftmesser sind vorteilhafterweise dazu eingerichtet, an ihren Ausgängen ein laminares Strömungsbild auszubilden, welches vorteilhafterweise ein luftseitiges Mischen von Luft aus der Umgebung der Arbeitsstationseinhausung und Luft aus der Prozessebene der Arbeitsstationseinhausung unterdrückt. Luftmesser sind unter anderem auch unter den Bezeichnungen Luftklinge, Luftschwert, Luftbürste oder Luftrakel bekannt.

Eine vorteilhafte Weiterbildung der Arbeitsstationseinhausung sieht vor, dass an den Stirnseiten der Installationsebene jeweils eine Gebläseeinheit, insbesondere ein Zentrifugalgebläse, in einem durch eine Trennwand innerhalb der Installationsebene räumlich abgetrennten Bereich angeordnet ist. Die Gebläseeinheiten sind dabei vorteilhafterweise jeweils einem der Luftmesser zugeordnet, wobei die jeweilige Gebläseeinheit insbesondere ausgebildet ist, das jeweilige Luftmesser mit Gebläseluft zu versorgen. Durch die jeweilige Trennwand sind die Gebläseeinheiten innerhalb der Installationsebene vorteilhafterweise von dem restlichen Raum der Installationsebene getrennt. Die Trennwand muss dabei nicht derart ausgebildet sein, dass diese eine ideal luftdichte Trennung von dem restlichen Volumenraum bereitstellt.

Weiter vorteilhaft weist der räumlich abgetrennte Bereich, in dem die Gebläseeinheit angeordnet ist, jeweils zur Umgebung der Arbeitsstationseinhausung wenigstens einen verschließbar ausgebildeten Lufteinlass, insbesondere ein Ventil, der geöffnet zur Einbringung von Luft von der Umgebung in den räumlich abgetrennten Bereich ausgebildet ist. Weiter vorteilhaft weist der räumlich abgetrennte Bereich jeweils zur Prozessebene wenigstens einen verschließbar ausgebildeten Lufteinlass, insbesondere ein Ventil, auf, der geöffnet zur Einbringung von Luft aus der Prozessebene in den räumlich abgetrennten Bereich ausgebildet ist. Als Lufteinlässe sind insbesondere ansteuerbare Strömungsventile vorgesehen. Alternativ dazu sind insbesondere mechanisch einstellbare Tellerventile, weiter insbesondere manuell mechanisch einstellbare Tellerventile, als Lufteinlässe vorgesehen, die vorzugsweise über eine Drehspindel bezüglich eines Luftdurchlasses einstellbar sind. Vorteilhafterweise lässt sich durch die Verwendung von Tellerventilen eine kostengünstige und effiziente Lösung bereitstellen. Vorteilhafterweise lässt sich unter Verwendung der Gebläseeinheiten bei geeigneter Einstellung der Lufteinlässe in der Prozessebene ein Unterdruck gegenüber einer äußeren Umgebung der Arbeitsstationseinhausung erzeugen. Der Unterdruck wird vorteilhafterweise durch das Schließen der sich zwischen der Installationsebene und der äußeren Umgebung in dem abgetrennten Bereich angeordneten Lufteinlässe sowie das Öffnen der zwischen der Prozessebene und der Installationsebene in dem abgetrennten Bereich angeordneten Lufteinlässe erzeugt. Die Gebläseeinheiten entnehmen so vorteilhafterweise die für die Funktionalität der Luftmesser benötigte Gebläseluft der Prozessebene der Arbeitsstationseinhausung, wodurch sich folglich vorteilhafterweise ein Unterdruck in der Prozessebene ausbildet, da das entnommene Luftvolumen nicht wieder in die Prozessebene zurückgeführt wird. Das Umluftsystem wird dabei vorteilhafterweise zur partikulären Reinigung der Luft in der Prozessebene weiterhin betrieben.

Gemäß einer weiteren besonders vorteilhaften Ausgestaltung der Arbeitsstationseinhausung umfasst das Umluftsystem wenigstens eine Filterlüftereinheit, insbesondere wenigstens eine Filter-Fan-Unit. Insbesondere ist vorgesehen, dass die wenigstens eine Filterlüftereinheit, insbesondere mehrere Filterlüftereinheiten, in die Abtrennung zwischen der Installationsebene und der Prozessebene eingelassen ist/sind. Die Luftzufuhr zur Versorgung der wenigstens einen Filterlüftereinheit wird dabei der Installationsebene entnommen. Vorteilhafterweise umfasst die wenigstens eine Filterlüftereinheit einen HEPA-Filter (HEPA: High Efficient Particulate Air) zur Filterung der Luft.

Des Weiteren umfasst das Umluftsystem insbesondere eine Mehrzahl von verschließbar ausgebildeten Lufteinlässen, insbesondere eine Mehrzahl von Ventilen, wobei die Lufteinlässe wiederum insbesondere als ansteuerbare Strömungsventile und/oder als Tellerventile, insbesondere als manuell mechanisch verstellbare Tellerventile, ausgebildet sein können. Insbesondere ist vorgesehen, dass zumindest eine Untermenge der Mehrzahl der Lufteinlässe als Tellerventil ausgebildet ist. Wenigstens einer der Lufteinlässe ist vorteilhafterweise zwischen der Installationsebene und der äußeren Umgebung der Arbeitsstationseinhausung, insbesondere mit einer Strömungsrichtung von der äußeren Umgebung in die Installationsebene, angeordnet und wenigstens einer der Lufteinlässe ist vorteilhafterweise zwischen der Installationsebene und der Prozessebene, insbesondere mit einer Strömungsrichtung von der Prozessebene in die Installationsebene, angeordnet. Vorteilhafterweise kann so die Luftbilanzierung innerhalb der Arbeitsstationseinhausung sowie die Luftbilanzierung im Austausch mit der äußeren Umgebung der Arbeitsstationseinhausung im Wesentlichen mittels der Lufteinlässe erfolgen, insbesondere mittels einfacher mechanischer Tellerventile. Vorteilhafterweise erfolgt der volumetrische Ausgleich der der Installationsebene entnommenen Luft also über in der Abtrennung zwischen der Installationsebene und der Prozessebene sowie an einer Außenwandwandung der Installationsumgebung zur äußeren Umgebung der Arbeitsstationseinhausung eingebrachte Lufteinlässe. Das der äußeren Umgebung der Arbeitsstationseinhausung entnommene Luftvolumen entspricht dabei vorteilhafterweise dem Anteil bereits gereinigter Zuluft, wobei das der Prozessebene entnommene Luftvolumen insbesondere der zu reinigende Anteil ist, weil sich darin luftgetragene Partikel befinden können, die insbesondere durch die in der Prozessebene der Arbeitsstationseinhausung ablaufenden Prozesse emittiert werden können. Vorteilhafterweise ist das Einstellen der Luftbilanzierung der wenigstens einen Filterlüftereinheit über die Lufteinlässe, insbesondere bei Ausbildung der Lufteinlässe als mechanisch einstellbare Tellerventile, einfach und manuell durchführbar.

Weiter vorteilhaft umfasst das Umluftsystem wenigstens eine Luftströmungseinheit, insbesondere wenigstens einen Rohrventilator. Die wenigstens eine Luftströmungseinheit ist dabei insbesondere zur dynamischen Rückführung von infolge der in der Prozessebene erfolgenden Bearbeitung der Werkstücke partikelkontaminierter Luft ausgebildet. Insbesondere ist die wenigstens eine Luftströmungseinheit zur Luftentnahme aus tieferliegenden Zonen, insbesondere aus bodennahen Zonen, der Prozessebene ausgebildet, wodurch die wenigstens eine Luftströmungseinheit vorteilhafterweise einem lufttechnischen Kurzschluss zwischen von der wenigstens einen Filterlüftereinheit in die Prozessebene ausgestoßenen Luftvolumina und den über die Lufteinlässe zwischen der Prozessebene und der Installationsebene angesaugten Luftvolumina entgegenwirkt. Insbesondere ist die Luftströmungseinheit derart angeordnet, dass mittels der wenigstens einen Luftströmungseinheit Luft aus einem bodennahen Bereich der Prozessebene entnommen werden kann. Für eine Luftentnahme aus tieferliegenden Zonen, insbesondere aus bodennahen Zonen, der Prozessebene umfassen die Luftströmungseinheiten vorteilhafterweise jeweils ein entsprechend langes in die Prozessebene hineinragendes Rohr, wobei die eigentliche Strömungseinheit, insbesondere der Rohrventilator, vorzugsweise in der Installationsebene angeordnet ist.

Gemäß einer weiteren vorteilhaften Ausgestaltung der Arbeitsstationseinhausung ist vorgesehen, dass wenigstens eine Untermenge der Lufteinlässe der Arbeitsstationseinhausung mit Strömungsrichtung in Richtung der Installationsebene jeweils einen Vorfilter aufweisen. Vorteilhafterweise wird durch die Vorfilter ein frühzeitiges Zusetzen der endständigen HEPA-Filter der Filterlüftereinheiten vermieden.

Eine weitere vorteilhafte Ausgestaltung sieht vor, dass der Prozessraum ein Segment oder mehrere in Längserstreckungsrichtung der Arbeitsstationseinhausung aufeinanderfolgende Segmente umfasst, wobei einem der Segmente jeweils eine der Filterlüftereinheiten und jeweils zumindest eine der Lufteinlässe zugeordnet sind. Weiter vorteilhaft ist zumindest zwischen zwei Segmenten eine Luftströmungseinheit angeordnet. Vorteilhafterweise ist die Errichtung der Arbeitsstationseinhausung durch den segmentierten Aufbau vereinfacht und vorteilhafterweise gut skalierbar. Weiter ist vorteilhafterweise ein modularer Aufbau der Arbeitsstationseinhausung vorgesehen, wobei der Aufbau und die Skalierbarkeit der Arbeitsstationseinhausung an unterschiedliche Anforderungen noch weiter vereinfacht wird. Insbesondere kann ein finaler Aufbau der Arbeitsstationseinhausung so vorteilhafterweise durch ein Zusammensetzen vorgefertigter Module und/oder ein Verlagern des vorgefertigten Moduls erfolgen, was insbesondere bei einem Aufbau in einer späteren Reinraumumgebung vorteilhaft ist.

Gemäß einer weiteren vorteilhaften Ausgestaltung umfasst die Arbeitsstationseinhausung mehrere Sensoreinheiten. Vorteilhafterweise umfasst die Arbeitsstationseinhausung dabei wenigstens eine Sensoreinheit, die zur Bestimmung eines Differenzdrucks zwischen der Umgebung der Arbeitsstationseinhausung und der Installationsebene ausgebildet ist. Weiter vorteilhaft umfasst die Arbeitsstationseinhausung wenigstens eine Sensoreinheit, die zur Bestimmung eines Differenzdrucks zwischen der Installationsebene und der Prozessebene ausgebildet ist. Weiter vorteilhaft umfasst die Arbeitsstationseinhausung wenigstens eine Sensoreinheit, die zur Bestimmung eines Differenzdrucks zwischen der Prozessebene und der äußeren Umgebung der Arbeitsstationseinhausung ausgebildet ist. Vorteilhafterweise stellen die Sensoreinheiten dabei Messwerte bereit, die vorteilhafterweise für ein Einstellen und/oder ein Steuern des Umluftsystems der Arbeitsstationseinhausung verwendet werden.

Darüber hinaus kann die Arbeitsstationseinhausung insbesondere weitere Sensoreinheiten umfassen. So kann insbesondere wenigstens eine Partikelsensoreinheit vorgesehen sein, die einen partikulären Zustand eines Luftvolumens der Prozessebene detektiert, und/oder wenigstens eine weitere Partikelsensoreinheit, die vorteilhafterweise Aufschluss über einen Zustand eines zu den Filterlüftereinheiten zurückgeführten Luftvolumens innerhalb der Installationsebene gibt. Vorteilhafterweise kann so eine Überwachung einer Partikelkontamination eines Aerosols in einer Reinraumumgebung der Arbeitsstationseinhausung erfolgen. Weitere Sensoreinheiten der Arbeitsstationseinhausung sind vorteilhafterweise ausgebildet, eine Temperatur und/oder eine Luftfeuchte innerhalb der Prozessebene zu erfassen. Vorteilhafterweise kann so überwacht werden, dass ein gleichbleibendes Produktionsklima vorherrscht.

Weiter vorteilhaft umfasst die Arbeitsstationseinhausung eine Mensch-Maschine-Schnittstelle. Vorteilhafterweise werden die von den Sensoreinheiten erfassten Werte an die Mensch-Maschine-Schnittstelle übertragen. Die so bereitgestellten Informationen, insbesondere die bereitgestellten Informationen bezüglich der Druckdifferenzen, werden dann vorteilhafterweise für eine Feinjustierung der Lufteinlässe, insbesondere der Tellerventile, genutzt. Vorteilhafterweise ist die Mensch-Maschine-Schnittstelle ausgebildet, die übertragenen Werte, insbesondere die Werte betreffend den jeweiligen Differenzdruck, auszugeben, insbesondere durch eine Visualisierung.

Die Arbeitsstationseinhausung kann darüber hinaus Wartungsklappen zu der Prozessebene und/oder zu der Installationsebene aufweisen.

Die Erfindung betrifft des Weiteren ein Verfahren betreffend den Betrieb der vorgeschlagenen Arbeitsstationseinhausung. So wird des Weiteren zur Lösung der eingangs genannten Aufgabe ein Verfahren zum Betreiben einer Arbeitsstationseinhausung, insbesondere einer erfindungsgemäß ausgebildeten Arbeitsstationseinhausung, vorgeschlagen, wobei das Verfahren vorteilhafterweise eine Luftbilanzierung innerhalb der Arbeitsstationseinhausung und der Umgebung der Arbeitsstationseinhausung über einstellbare Lufteinlässe, insbesondere über mechanisch einstellbare Lufteinlässe, weiter insbesondere über Tellerventile, und eine dynamische Luftrückführung vorsieht. Vorteilhafterweise ist so insbesondere ein Betrieb der Arbeitsstationseinhausung in einer Reinraumumgebung möglich, insbesondere indem in einer Prozessebene der Arbeitsstationseinhausung gegenüber einer äußeren Umgebung der Arbeitsstationseinhausung ein Unterdruck eingestellt wird. Insbesondere sieht das Verfahren ein Einstellen der Lufteinlässe und ein Ansteuern der aktiven Komponenten des Umluftsystems der vorgeschlagenen Arbeitsstationseinhausung derart vor, dass die Arbeitsstationseinhausung in der Prozessebene kontinuierlich mit einem Unterdruck oder dass die Arbeitsstationseinhausung in der Prozessebene kontinuierlich mit einem Überdruck betrieben werden kann. Ein Überdruck wird in der Prozessebene vorteilhafterweise erzeugt, indem eine Zuluft für die Filterlüftereinheiten über die geöffneten Lufteinlässe, die zwischen der Installationsebene und der äußeren Umgebung angeordnet sind, zugeführt wird, während die Lufteinlässe, die zwischen der Prozessebene und der Installationsebene angeordnet sind, vorteilhafterweise hinsichtlich des Luftdurchflusses reduziert werden. Die Luftströmungseinheiten der dynamischen Rückströmung werden vorteilhafterweise derart angesteuert, dass ein verringertes Luftvolumen in die Installationsebene zurückgeführt wird. Die Lufteinlässe, die in den für die Gebläseeinheiten abgetrennten Bereiche der Installationsebene zwischen der Prozessebene und der Installationsebene angeordnet sind, sind dabei vorteilhafterweise geschlossen und die in den für die Gebläseeinheiten abgetrennten Bereiche zwischen der Installationsebene und der äußeren Umgebung angeordneten Lufteinlässe sind vorteilhafterweise geöffnet. Insgesamt wird der Prozessebene auf diese Weise vorteilhafterweise mehr Luftvolumen zugeführt als der Prozessebene entnommen wird. Folglich stellt sich vorteilhafterweise ein Überdruck in der Prozessebene ein.

Gemäß einem weiteren Aspekt des Verfahrens erfolgt beim Betreiben der Arbeitsstationseinhausung ein unterbrechungsfreier Materialtransport in die Arbeitsstationseinhausung und aus der Arbeitsstationseinhausung, also insbesondere ein unterbrechungsfreier Materialtransport in die Prozessebene der Arbeitsstationseinhausung hinein und aus der Prozessebene der Arbeitsstationseinhausung heraus. Vorteilhafterweise werden dafür Werkstückträger über ein durch die Prozessebene der Arbeitsstationseinhausung führendes Transportsystem, insbesondere eine Friktionsrollenkette, in die Prozessebene ein- und ausgebracht. Vorteilhafterweise werden hierdurch die Taktzeiten verkürzt. Vorteilhafterweise wird dabei an der Einbringöffnung der Prozessebene und an der Ausbringöffnung der Prozessebene ein laminares Strömungsbild erzeugt, insbesondere mittels eines Luftmessers, wobei die Strömung vorteilhafterweise von oben nach unten gerichtet aufrechterhalten wird.

Vorteilhafterweise ist vorgesehen, dass die Arbeitsstationseinhausung in einem ersten Betriebsmodus derart betrieben wird, dass in der Prozessebene gegenüber der äußeren Umgebung der Arbeitsstationseinhausung beim Betreiben der Arbeitsstationseinhausung ein Unterdruck aufrechterhalten wird, wobei die Arbeitsstationseinhausung dabei insbesondere in einem Reinraum betrieben wird.

Eine weitere vorteilhafte Ausgestaltung sieht vor, dass die Arbeitsstationseinhausung in einem zweiten Betriebsmodus derart betrieben wird, dass in der Prozessebene gegenüber der äußeren Umgebung der Arbeitsstationseinhausung beim Betreiben der Arbeitsstationseinhausung ein Überdruck aufrechterhalten wird. Vorteilhafterweise kann so in der Prozessebene der Arbeitsstationseinhausung ein sauberkeitskritischer Materialbearbeitungsprozess durchgeführt werden, wenn der Aufstellort selbst hinsichtlich der Partikelreinheit eine ungünstigere Umgebung als der Innerraum der Prozessebene der Arbeitsstationseinhausung darstellt.

Insbesondere sieht ein Betreiben der Arbeitsstationseinhausung mit einer Prozessebene und einer darüber angeordneten Installationsebene vor, dass zur Erzeugung eines Überdrucks in der Prozessebene die Lufteinlässe zwischen der Installationsebene und der äußeren Umgebung der Arbeitsstationseinhausung geöffnet werden, ein Luftdurchsatz von der Prozessebene in die Installationsebene durch ein zumindest teilweises Schließen der Lufteinlässe zwischen der Prozessebene und der Installationsebene verringert wird, und der Luftdurchsatz von der Prozessebene in die Installationsebene von der Prozessebene über die Luftströmungseinheit in die Installationsebene reduziert wird, wobei die wenigstens eine Filterlüftereinheit in der Installationsebene der Arbeitsstationseinhausung mehr Luftvolumen ansaugt und in die Prozessebene abgibt, als aus der Prozessebene zugeführt wird. Sind die Lufteinlässe elektrisch ansteuerbare Strömungsventile, kann vorteilhafterweise das Erzeugen des Überdrucks vollständig über eine entsprechende Ansteuerung des Umluftsystems erfolgen. Bei einer kostengünstigeren Ausgestaltung, bei der die Lufteinlässe durch Tellerventile gebildet sind, werden die Teller der Tellerventile händisch ein- beziehungsweise ausgedreht, um die Tellerventile zu schließen beziehungsweise zu öffnen.

Weiter vorteilhaft sieht ein Betreiben der Arbeitsstationseinhausung mit einer Prozessebene und einer darüber angeordneten Installationsebene vor, dass zur Erzeugung eines Unterdrucks in der Prozessebene die den Gebläseeinheiten zugeordneten Lufteinlässe, die insbesondere in den durch die jeweilige Trennwand abgetrennten Bereichen der Installationsebene angeordnet sind, und die zwischen der Prozessebene und der Installationsebene angeordnet sind, geöffnet werden. Darüber hinaus werden die den Gebläseeinheiten zugeordneten Lufteinlässe, die insbesondere in den durch die jeweilige Trennwand abgetrennten Bereichen der Installationsebene angeordnet sind, und die zwischen der Installationsebene und der Umgebung der Arbeitsstationseinhausung angeordnet sind, geschlossen. Zudem wird der Prozessebene mittels der in der Installationsebene in den abgetrennten Bereichen angeordneten Gebläseeinheiten Luftvolumen entnommen. Durch die Trennwandungen in der Installationsebene zur räumlichen Abtrennung der Gebläseeinheiten, sind die Gebläseeinheiten in der Installationsebene also räumlich getrennt von der wenigstens einen Filterlüftereinheit angeordnet. Das Luftvolumen zur Unterdruckerzeugung wird also vorteilhafterweise der Prozessebene der Arbeitsstationseinhausung durch die geöffneten, an der Trennung zwischen der Prozessebene und der Installationsebene angeordneten Lufteinlässe entnommen.

Gemäß einer weiteren vorteilhaften Ausgestaltung wird beim Betreiben der Arbeitsstationseinhausung mittels des Umluftsystems, insbesondere mittels der wenigstens einen Filterlüftereinheit, in der Prozessebene der Arbeitsstationseinhausung eine turbulente Mischströmung als Verdrängungsströmung ausgebildet. Der Betrieb der Arbeitsstationseinhausung erfolgt dabei in einer Umgebung, in der ebenfalls eine turbulente Mischströmung vorherrscht oder es wird - insbesondere mit einem nicht mit der Arbeitsstationseinhausung verbundenem System - eine solche turbulente Mischströmung ausgebildet. Weiter sieht diese Ausgestaltung vor, dass an der Einbringöffnung der Prozessebene der Arbeitsstationseinhausung und an der Ausbringöffnung der Prozessebene der Arbeitsstationseinhausung mittels der Luftmesser jeweils ein stationäres laminares Strömungsbild ausgebildet wird, insbesondere ein sich im Wesentlichen senkrecht von oben nach unten erstreckendes laminares Strömungsbild. Vorteilhafterweise werden die Luftmassen innerhalb der Prozessebene der Arbeitsstationseinhausung und außerhalb der Arbeitsstationseinhausung so an einer Vermischung gehindert.

Weiter vorteilhaft ist vorgesehen, dass die Arbeitsstationseinhausung so ausgestaltet ist, dass die partikuläre Verunreinigung des Luftvolumens innerhalb der Prozessebene eine partikelseitige Klassifikation ISO 6 oder höherwertiger nach DIN EN ISO 14644-1 zulässt.

Weitere vorteilhafte Einzelheiten, Merkmale und Ausgestaltungsdetails der Erfindung werden im Zusammenhang mit den in den Figuren (Fig.: Figur) dargestellten Ausführungsbeispielen näher erläutert. Dabei zeigt:

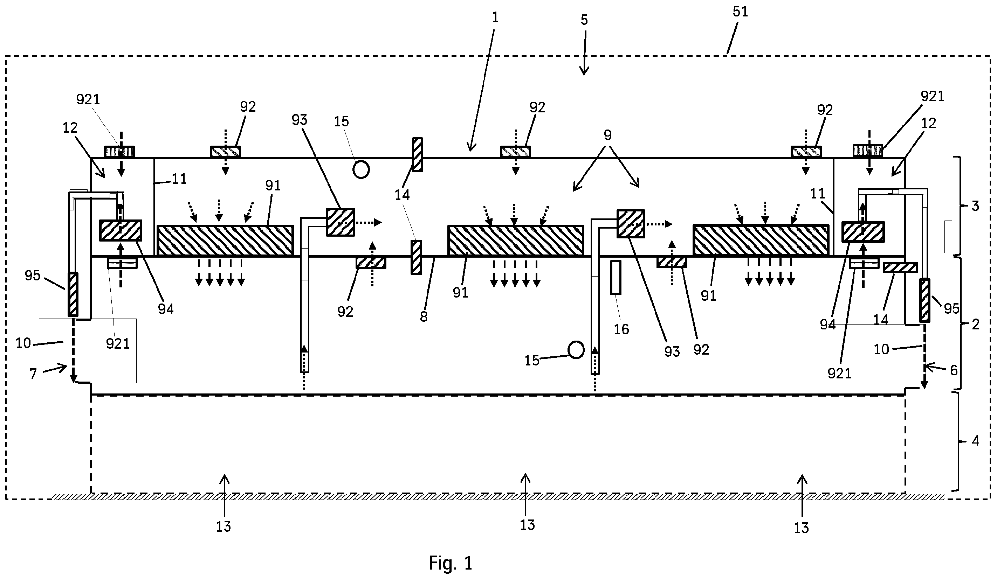

- Fig. 1: in einer schematischen Seitenansicht ein Ausführungsbeispiel für eine erfindungsgemäß ausgebildete Arbeitsstationseinhausung.

In Fig. 1 ist ein Ausführungsbeispiel für eine Arbeitsstationseinhausung 1 dargestellt, die in einem geschlossenen Reinraum betrieben wird. Die äußere Wandung 51 des Reinraums ist dabei in Fig. 1 symbolisch durch eine gestrichelte Linie dargestellt. Die Arbeitsstationseinhausung 1 wird insofern in einer äußeren Umgebung 5 betrieben, die einer Reinraumumgebung entspricht. In der Arbeitsstationseinhausung 1 können dabei, räumlich abgetrennt von der Reinraumumgebung, Werkstücke bearbeitet werden, wozu entsprechende Werkzeuge (in Fig. 1 nicht explizit dargestellt) in der Arbeitsstationseinhausung 1 angeordnet sind. Die eigentlichen Arbeiten finden dabei in einer Prozessebene 2 der Arbeitsstationseinhausung 1 statt, die einen im Wesentlichen geschlossenen Bereich innerhalb der Arbeitsstationseinhausung 1 darstellt. Die Prozessebene 2 weist dabei eine Einbringöffnung 6 zum Einbringen von zu bearbeitenden Werkstücken und eine Ausbringöffnung 7 zum Ausbringen von bearbeiteten Werkstücken auf, die sich jeweils stirnseitig an einander gegenüberliegenden Enden der Arbeitsstationseinhausung 1 befinden. Über die Einbringöffnung 6 und die Ausbringöffnung 7 erfolgt dabei in diesem Ausführungsbeispiel ein unterbrechungsfreier Materialtransport mittels eines Transportsystems, dass zumindest teilweise in der Arbeitsstationseinhausung 1 angeordnet ist, insbesondere mittels einer Friktionsrollenkette, mittels der Materialien auf Werkstückträgern in die Prozessebene 2 eingebracht werden können. In Fig. 1 ist dabei allgemein eine Transportebene 4 unterhalb der Prozessebene 2 dargestellt, die sich insbesondere auch in Längsrichtung über die Arbeitsstationseinhausung 1 hinaus erstrecken kann. Die Transportebene 4 ermöglicht vorteilhafterweise einen Werkstückträger-Rücklauf, wobei der Werkstückträger-Vorlauf vorteilhafterweise in der Prozessebene 2 erfolgt. In dem in Fig. 1 dargestellten Ausführungsbeispiel ist dabei vorgesehen, dass Zellkörper für eine Batteriemodulherstellung in die Prozessebene 2 eingebracht werden, innerhalb der Prozessebene 2 mit einem Elektrolyten befüllt werden und innerhalb der Prozessebene 2 die Zellkörper nach dem Befüllen verschlossen werden. Darüber hinaus kann alternativ oder zusätzlich ein Verschweißen von Zellableitern in der Prozessebene 2 vorgesehen sein, um die Zellkörper miteinander zu verschalten.

Unabhängig von der Spezifikation der innerhalb der Arbeitsstationseinhausung 1 stattfindenden Prozesse wird vorliegend davon ausgegangen, dass diese Prozesse dazu geeignet sind, luftgetragene Partikel freizusetzen und dadurch die im Inneren der Arbeitsstationseinhausung 1 hergestellten Bauteile und/oder die die Arbeitsstationseinhausung 1 umgebende Reinraumumgebung unzulässig zu kontaminieren. Um dies zu vermeiden, ist die Arbeitsstationseinhausung 1 mit Reinlufttechnik ausgerüstet, wodurch eine Reinraumtauglichkeit der Arbeitsstationseinhausung 1 bereitgestellt wird.

Die Reinlufttechnik-Komponenten der Arbeitsstationseinhausung 1 sind dabei als Umluftsystem 9 im Wesentlichen in einer ebenfalls im Wesentlichen geschlossenen Installationsebene 3 der Arbeitsstationseinhausung 1 angeordnet. Diese Installationsebene 3 ist dabei durch eine Abtrennung 8 von der Prozessebene 2 getrennt oberhalb der Prozessebene 2 angeordnet. Das Umluftsystem 9 ist dabei für einen einstellbaren Lufttransfer zwischen der Installationsebene 3 und der Prozessebene 2 ausgebildet und derart einstellbar, dass in der Prozessebene 2 ein Druckgefälle gegenüber der äußeren Umgebung 5 der Arbeitsstationseinhausung 1 aufgebaut und aufrechterhalten werden kann. Dabei ist insbesondere vorgesehen, dass zur Vermeidung von Verunreinigungen in der Reinraumumgebung 5 durch von in der Arbeitsstationseinhausung 1 ablaufenden Prozessen mit dem Umluftsystem 2 ein Unterdruck in der Prozessebene 2 erzeugt und aufrechterhalten wird. Die Arbeitsstationseinhausung 1 und deren Umlufttechniksystem 9 sind aber auch dazu ausgebildet, die Prozesse innerhalb der Prozessebene 2 mit einem Überdruck gegenüber der äußeren Umgebung 5 ablaufen zu lassen, insbesondere wenn innerhalb der Prozessebene 2 höhere Anforderungen an eine Partikelreinheit bestehen, als in der äußeren Umgebung 5 der Arbeitsstationseinhausung 1. Mit der vorliegenden Arbeitsstationseinhausung 1 realisierbare Luftströmungen sind in Fig. 1 dabei durch die Pfeile mit den geschlossenen Pfeilspitzen symbolisch dargestellt, wobei die Pfeilspitzen die Strömungsrichtung andeuten.

Das in der Installationsebene 3 angeordnete Umluftsystem 9 umfasst dabei in diesem Ausführungsbeispiel drei Filterlüftereinheiten 91, nachfolgend auch kurz als FFUs (FFU: Filter Fan Units) bezeichnet, die in der Abtrennung 8 zwischen der Prozessebene 2 und der Installationsebne 3 angeordnet sind. Die Zuluft zur Versorgung der FFUs wird dabei der Installationsebene entnommen. Darüber hinaus umfasst das Umluftsystem 9 eine Mehrzahl von verschließbar ausgebildeten und mit Vorfiltern versehene Lufteinlässen 92, 921, die vorzugsweise als Ventile ausgebildet sind. Insbesondere dann, wenn ein häufigerer Wechsel zwischen einem Unterdruckbetrieb in der Prozessebene 2 und einem Überdruckbetrieb in der Prozessebene 2 für die Arbeitsstationseinhausung 1 vorgesehen ist, sind elektrisch ansteuerbare Strömungsventile als Lufteinlässe 92, 921 vorteilhaft. In dem vorliegenden Ausführungsbeispiel ist dabei für eine kostengünstige Realisierung mit nicht oder nur selten wechselnden Betriebsmodi mechanisch verschließbare Tellerventile vorgesehen, die insbesondere über eine entsprechende Drehspindel manuell zwischen einer vollständig geöffneten Stellung und einer vollständig geschlossenen Stellung eingestellt werden können. In dem in Fig. 1 dargestellten Ausführungsbeispiel sind dabei beispielhaft neun Lufteinlässe 92, 921 vorgesehen. Davon sind insgesamt vier Lufteinlässe 921 in innerhalb der Installationsebene 3 separierten Bereichen 12 vorgesehen, wobei jeweils zwei der Lufteinlässe 921 zur Luftaufnahme aus der äußeren Umgebung 5 der Arbeitsstationseinhausung 1 zwischen der Installationsebene 3 und der äußeren Umgebung 5 angeordnet sind. Zwei weitere der Lufteinlässe 921 sind jeweils zur Luftaufnahme aus der Prozessebene 3 zwischen der Installationsebene 3 und der Prozessebene 2 angeordnet. Von den weiteren Lufteinlässen 92 sind drei Lufteinlässe 92 zur Luftaufnahme aus der äußeren Umgebung 5 der Arbeitsstationseinhausung 1 zwischen der Installationsebene 3 und der äußeren Umgebung 5 außerhalb der separierten Bereiche 12 angeordnet und drei Lufteinlässe 92 zur Luftaufnahme aus der Prozessebene 3 zwischen der Installationsebene 3 und der Prozessebene 2 außerhalb der separierten Bereiche 12 angeordnet. Die zwischen der Installationsebene 3 und der äußeren Umgebung 5 angeordneten Lufteinlässe 92, 921 sind dabei mit einer Strömungsrichtung von der äußeren Umgebung 5 in die Installationsebene 3 angeordnet und die Lufteinlässe 92, 921 zwischen der Installationsebene 3 und der Prozessebene 2 sind mit einer Strömungsrichtung von der Prozessebene 2 in die Installationsebene 3 angeordnet.

Das Umluftsystem 9 der Arbeitsstationseinhausung 1 umfasst in diesem Ausführungsbeispiel des Weiteren zwei als Rohrventilatoren ausgebildete Luftströmungseinheiten 93. Die eigentlichen Ventilatoreinheiten der Luftströmungseinheiten 93 sind dabei jeweils in der Installationsebene 3 angeordnet und ausgebildet, über ein mit der Ventilatoreinheit verbundenes Rohr, dass weit in die Prozessebene 2 hineinreicht, Luft aus einem bodennahen Bereich der Prozessebene 2 zu entnehmen. Die Luftströmungseinheiten 93 sind dabei zur dynamischen Rückführung von infolge des Bearbeitungsprozesses partikelkontaminierter Luft aus der Prozessebene 2 in die Installationsebne 3 ausgebildet. Dadurch, dass die Luftströmungseinheiten über die Rohre tief in die Prozessebene 2 hineinreichen, wird zudem einem luftströmungstechnischen Kurzschluss zwischen in die FFUs über die untere Lufteinlässe 92 aus der Prozessebene 2 eingesaugter Luft und von den FFUs in die Prozessebene 2 ausgestoßener Luft entgegengewirkt.

Darüber hinaus ist an jeder Stirnseite der Installationsebene 3 der Arbeitsstationseinhausung 1 jeweils eine Gebläseeinheit 94 in dem durch eine Trennwand 11 innerhalb der Installationsebene 3 räumlich abgetrennten Bereich 12 angeordnet, wobei die Trennwände 11 die separierten Bereiche 12 nicht vollständig luftdicht gegenüber der restlichen Installationsebene 3 abtrennen. Die Gebläseeinheiten 94 sind dabei jeweils über eine Luftführungseinheit, insbesondere eine Rohrleitung, mit einem jeweils oberhalb der Einbringöffnung 6 und oberhalb der Ausbringöffnung 7 angeordneten und sich über die die vollständige Breite der Einbringöffnung 6 beziehungsweise der Ausbringöffnung 7 erstreckendem Luftmesser 95 verbunden. Die Gebläseeinheiten 94 versorgen dabei jeweils die Luftmesser 95 zur Erzeugung einer Luftbarriere 10 mit Gebläseluft, wobei die Luftbarriere 10 durch die Luftmesser 95 als stationäres laminares Strömungsbild ausgebildet wird.

In diesem Ausführungsbeispiel umfasst die Prozessebene 2 der Arbeitsstationseinhausung 1 drei in Längserstreckungsrichtung der Arbeitsstationseinhausung 1 aufeinanderfolgende Segmente 13, wobei jedem der Segmente 13 jeweils eine der FFUs 91 und jeweils zumindest eine der Lufteinlässe 92 zugeordnet ist. Weiter kann die Arbeitsstationseinhausung 1 in diesem Ausführungsbeispiel modular aufgebaut sein, wobei dann zumindest jedes der Segmente 13 ein Modul bildet. Dabei kann die Arbeitsstationseinhausung 1 durch das Vorsehen mehrere mittlerer Segmente 13 leicht in Bezug auf andere Größenanforderungen skaliert werden.

Die Arbeitsstationseinhausung 1 weist zudem eine eine Mehrzahl von Sensoreinheiten 14, 15, 16 umfassende Sensortechnik auf. So umfasst die Arbeitsstationseinhausung 1 Sensoreinheiten 14 zur Bestimmung eines Differenzdrucks zwischen der äußeren Umgebung 5 der Arbeitsstationseinhausung 1 und der Installationsebene 3, Sensoreinheiten 14 zur Bestimmung eines Differenzdrucks zwischen der Installationsebene 3 und der Prozessebene 2 und Sensoreinheiten 14 zur Bestimmung eines Differenzdrucks zwischen der Prozessebene 2 und der äußeren Umgebung 5 der Arbeitsstationseinhausung 1. Mittels dieser Sensoreinheiten 14 kann dabei insbesondere kontrolliert werden, dass der Druck in der Prozessebene 2 der Arbeitsstationseinhausung 1 korrekt eingestellt ist und wie gewünscht aufrecht erhalten wird. Des Weiteren umfasst die Arbeitsstationseinhausung 1 Sensoreinheiten 15 zur Erfassung der partikulären Luftreinheit, wobei mit diesen Sensoreinheiten 15 insbesondere kontrolliert wird, dass die partikulären Reinraumbedingungen eingehalten werden. Darüber hinaus kann mittels der von den Sensoreinheiten 15 bereitgestellten Messwerten erkannt werden, wenn die Vorfilter der Lufteinlässe 92, 921 und die Filter der FFUs ausgetauscht werden sollten. Zudem umfasst die Arbeitsstationseinhausung 1 Sensoreinheiten 16, die dazu ausgebildet sind, die relative Luftfeuchtigkeit und die Temperatur zu bestimmten. Mittels der von diesen Sensoreinheiten 16 bereitgestellten Messwerten kann dabei ein Einhalten von gleichbleibenden Prozessbedingungen bei der in der Prozessebene 2 erfolgenden Bearbeitung kontrolliert werden.

Mittels des Umluftsystems 9 erfolgt beim Betrieb der Arbeitsstationseinhausung 1 eine Luftbilanzierung innerhalb der Prozessebene 2 der Arbeitsstationseinhausung 1 und der äußeren Umgebung 5 der Arbeitsstationseinhausung 1. Dazu werden die Lufteinlässe 92, 921 geeignet eingestellt und die FFUs 91 sowie die Luftströmungseinheiten 93 für eine dynamische Luftrückführung in geeigneter Weise angesteuert. Für den in dem vorliegenden Ausführungsbeispiel vorgesehenen Unterdruckbetrieb in der Prozessebene 3 werden dabei in den abgetrennten Bereichen 12 die Lufteinlässe 921 zwischen der Prozessebene 2 und der Installationsebene 3 geöffnet und dann offengehalten. Die in den abgetrennten Bereichen 12 zwischen der Installationsebene 2 und der äußeren Umgebung 5 angeordneten Lufteinlässe 921 werden geschlossen und dann geschlossen gehalten. Mittels der in den abgetrennten Bereichen 12 angeordneten Gebläseeinheiten 94 wird der Prozessebene 2 dabei Luftvolumen entnommen, das zur Ausbildung der Luftbarriere 10 mittels der Luftmesser 95 genutzt wird.

Darüber hinaus wird über die unteren Lufteinlässe 92 und die Luftströmungseinheiten 93 der Prozessebene 2 Luft entnommen, die dann aber wieder gereinigt über die FFUs zugeführt wird. Dadurch bildet sich in der Prozessebene 2 eine turbulente Mischströmung als Verdrängungsströmung aus. Da die Arbeitsstationseinhausung 1 in dem vorliegenden Ausführungsbeispiel in einem Reinraum betrieben wird, herrscht auch in der äußeren Umgebung 5 der Arbeitsstationseinhausung 1 vorrangig eine turbulente Mischströmung vor. Da an der Einbringöffnung 6 der Prozessebene 2 und an der Ausbringöffnung 7 der Prozessebene 2 dabei zudem mittels der Luftmesser 95 jeweils ein stationäres laminares Strömungsbild als Luftbarriere 10 ausgebildet wird, werden die Luftmassen innerhalb der Prozessebene 2 der Arbeitsstationseinhausung 1 und die Luftmassen in der äußeren Umgebung 5 der Arbeitsstationseinhausung 1 an einer Vermischung gehindert.

Mittels der in Fig. 1 gezeigten Arbeitsstationseinhausung 1 ist darüber hinaus durch folgende Einstellungen auch ein Überdruckbetriebe in der Prozessebene 2 gegenüber der äußeren Umgebung 5 der Arbeitsstationseinhausung 1 möglich. Für ein Erzeugen und aufrecht Erhalten eines Überdrucks in der Prozessebene 2 werden die oberen Lufteinlässe 92, die zwischen der Installationsebene 3 und der äußeren Umgebung 5 der Arbeitsstationseinhausung 1 angeordnet sind, geöffnet beziehungsweise offengehalten. Durch ein zumindest teilweises Schließen, insbesondere vollständiges Schließen, und ein geschlossen Halten der zwischen der Prozessebene (2) und der Installationsebene (3) angeordneten unteren Lufteinlässe 92 wird ein Ansaugen von Luft aus der Prozessebene 2 in die Installationsebene 3 verringert. Zudem wird ein Luftdurchsatz von der Prozessebene 2 in die Installationsebene 3 über die Luftströmungseinheiten 93 reduziert. Die FFUs 91 werden dann so betrieben, dass in der Installationsebene 3 mehr Luftvolumen angesaugt und in die Prozessebene 2 abgegeben wird, als aus der Prozessebene 2 in die Installationsebene 3 zugeführt wird.

Das in Fig. 1 dargestellte und im Zusammenhang mit Fig. 1 erläuterte Ausführungsbeispiel dient der Erläuterung der Erfindung und ist für diese nicht beschränkend.

### Bezugszeichenliste

- 1: Arbeitsstationseinhausung
- 2: Prozessebene
- 3: Installationsebene
- 4: Transportebene
- 5: äußere Umgebung (Reinraum)
- 51: Wandung der äußeren Umgebung
- 6: Einbringöffnung
- 7: Ausbringöffnung
- 8: Abtrennung
- 9: Umluftsystem
- 91: Filterlüftereinheit
- 92: Lufteinlass
- 921: Lufteinlass des Bereichs 12
- 93: Luftströmungseinheit
- 94: Gebläseeinheit (Zentrifugalgebläse)
- 95: Luftmesser
- 10: Luftbarriere (stationäres laminares Strömungsbild)
- 11: Trennwand
- 12: räumlich abgetrennter Bereich
- 13: Segment
- 14: Sensoreinheit zur Bestimmung eines Differenzdrucks
- 15: Sensoreinheit zur Erfassung der partikulären Luftreinheit
- 16: Sensoreinheit zur Bestimmung der relativen Luftfeuchtigkeit und der Temperatur

## Patentansprüche

1. Arbeitsstationseinhausung (1) zur Bearbeitung von Werkstücken in einer räumlich separierten Umgebung, wobei die Arbeitsstationseinhausung (1) eine Prozessebene (2) mit einer Einbringöffnung (6) zum Einbringen von zu bearbeitenden Werkstücken und eine Ausbringöffnung (7) zum Ausbringen von bearbeiteten Werkstücken umfasst, **dadurch gekennzeichnet, dass** die Arbeitsstationseinhausung (1) oberhalb der Prozessebene (2) eine Installationsebene (3) umfasst, die durch eine Abtrennung (8) räumlich von der Prozessebene (2) getrennt ist, wobei die Installationsebene (3) für einen einstellbaren Lufttransfer zwischen der Installationsebene (3) und der Prozessebene (2) ein Umluftsystem (9) aufweist, und wobei das Umluftsystem (9) derart einstellbar ist, dass in der Prozessebene (2) ein Druckgefälle gegenüber einer äußeren Umgebung (5) der Arbeitsstationseinhausung (1) aufrecht erhalten werden kann.

2. Arbeitsstationseinhausung (1) nach Anspruch 1, **dadurch gekennzeichnet, dass** der Einbringöffnung (6) und der Ausbringöffnung (7) jeweils eine Luftbarriere (10) zugeordnet ist, wobei die Arbeitsstationseinhausung (1) die Luftbarriere (10) erzeugende Luftmesser (95) umfasst.

3. Arbeitsstationseinhausung (1) nach Anspruch 2, **dadurch gekennzeichnet, dass** an den Stirnseiten der Installationsebene (3) jeweils eine Gebläseeinheit (94) in einem durch eine Trennwand (11) innerhalb der Installationsebene (3) räumlich abgetrennten Bereich (12) angeordnet ist, wobei die Gebläseeinheiten (94) jeweils einem der Luftmesser (95) zugeordnet sind, und wobei die jeweilige Gebläseeinheit (94) ausgebildet ist, das jeweilige Luftmesser (95) mit Gebläseluft zu versorgen.

4. Arbeitsstationseinhausung (1) nach Anspruch 3, **dadurch gekennzeichnet, dass** der räumlich abgetrennte Bereich (12), in dem die Gebläseeinheit (94) angeordnet ist, jeweils zur äußeren Umgebung (5) der Arbeitsstationseinhausung (1) wenigstens einen verschließbar ausgebildeten Lufteinlass (921) aufweist, der geöffnet zur Einbringung von Luft von der äußeren Umgebung (5) in den räumlich abgetrennten Bereich (12) ausgebildet ist, und jeweils zur Prozessebene (2) wenigstens einen verschließbar ausgebildeten Lufteinlass (921) aufweist, der geöffnet zur Einbringung von Luft aus der Prozessebene (2) in den räumlich abgetrennten Bereich (12) ausgebildet ist.

5. Arbeitsstationseinhausung (1) nach einem der vorstehenden Ansprüche, **dadurch gekennzeichnet, dass** das Umluftsystem (9) wenigstens eine Filterlüftereinheit (91), wenigstens eine Luftströmungseinheit (93) und eine Mehrzahl von verschließbar ausgebildeten Lufteinlässen (92) umfasst, wobei wenigstens einer der Lufteinlässe (92) zwischen der Installationsebene (3) und der äußeren Umgebung (5) der Arbeitsstationseinhausung (1) mit einer Strömungsrichtung von der Umgebung (5) in die Installationsebene (3) angeordnet ist und wenigstens einer der Lufteinlässe (92) zwischen der Installationsebene (3) und der Prozessebene (2) mit einer Strömungsrichtung von der Prozessebene (2) in die Installationsebene (3) angeordnet ist.

6. Arbeitsstationseinhausung (1) nach Anspruch 5, **dadurch gekennzeichnet, dass** die wenigstens eine Luftströmungseinheit (93) derart angeordnet ist, dass mittels der wenigstens einen Luftströmungseinheit (93) Luft aus einem bodennahen Bereich der Prozessebene (2) entnommen werden kann.

7. Arbeitsstationseinhausung (1) nach Anspruch 5 oder Anspruch 6, **dadurch gekennzeichnet, dass** die Prozessebene (2) ein Segment (13) oder mehrere in Längserstreckungsrichtung der Arbeitsstationseinhausung (1) aufeinanderfolgende Segmente (13) umfasst, wobei einem der Segmente (13) jeweils eine der Filterlüftereinheiten (91) und jeweils zumindest eine der Lufteinlässe (92) zugeordnet sind.

8. Arbeitsstationseinhausung (1) nach einem der vorstehenden Ansprüche, **gekennzeichnet durch** Sensoreinheiten (14) zur Bestimmung eines Differenzdrucks zwischen der äußeren Umgebung (5) der Arbeitsstationseinhausung (1) und der Installationsebene (3), und/oder
zwischen der Installationsebene (3) und der Prozessebene (2), und/oder zwischen der Prozessebene (2) und der äußeren Umgebung (5) der Arbeitsstationseinhausung (1).

9. Verfahren zum Betreiben einer Arbeitsstationseinhausung (1), insbesondere einer Arbeitsstationseinhausung (1) nach einem der vorstehenden Ansprüche, **dadurch gekennzeichnet, dass** eine Luftbilanzierung innerhalb der Arbeitsstationseinhausung (1) und der äußeren Umgebung (5) der Arbeitsstationseinhausung (1) über einstellbare Lufteinlässe (92, 921) und eine dynamische Luftrückführung erfolgt.

10. Verfahren nach Anspruch 9, **dadurch gekennzeichnet, dass** beim Betreiben der Arbeitsstationseinhausung (1) ein unterbrechungsfreier Materialtransport in die Arbeitsstationseinhausung (1) und aus der Arbeitsstationseinhausung (1) erfolgt.

11. Verfahren nach Anspruch 9 oder Anspruch 10, **dadurch gekennzeichnet, dass** in der Prozessebene (2) gegenüber der äußeren Umgebung (5) der Arbeitsstationseinhausung (1) beim Betreiben der Arbeitsstationseinhausung (1) ein Unterdruck aufrechterhalten wird.

12. Verfahren nach Anspruch 9 oder Anspruch 10, **dadurch gekennzeichnet, dass** in der Prozessebene (2) gegenüber der äußeren Umgebung (5) der Arbeitsstationseinhausung (1) beim Betreiben der Arbeitsstationseinhausung (1) ein Überdruck aufrechterhalten wird.

13. Verfahren nach Anspruch 12, **dadurch gekennzeichnet, dass** zur Erzeugung eines Überdrucks in der Prozessebene (2) die Lufteinlässe (92) zwischen der Installationsebene (3) und der äußeren Umgebung (5) der Arbeitsstationseinhausung (1) geöffnet werden, ein Luftdurchsatz von der Prozessebene (2) in die Installationsebene (3) durch ein zumindest teilweises Schließen der Lufteinlässe (92) zwischen der Prozessebene (2) und der Installationsebene (3) verringert wird, und der Luftdurchsatz von der Prozessebene (2) über die wenigstens eine Luftströmungseinheit (93) in die Installationsebene (3) reduziert wird, wobei die wenigstens eine Filterlüftereinheit (91) in der Installationsebene (3) der Arbeitsstationseinhausung (1) mehr Luftvolumen ansaugt und in die Prozessebene (2) abgibt, als aus der Prozessebene (2) zugeführt wird.

14. Verfahren nach Anspruch 11, **dadurch gekennzeichnet, dass** zur Erzeugung eines Unterdrucks in der Prozessebene (2) die den Gebläseeinheiten (94) zugeordneten Lufteinlässe (921) zwischen der Prozessebene (2) und der Installationsebene (3) geöffnet werden, die den Gebläseeinheiten (94) zugeordneten Lufteinlässe (921) zwischen der Installationsebene (2) und der äußeren Umgebung (5) der Arbeitsstationseinhausung (1) geschlossen werden und der Prozessebene (2) mittels der in der Installationsebene (3) in den abgetrennten Bereichen (12) angeordneten Gebläseeinheiten (94) Luftvolumen entnommen wird.

15. Verfahren nach einem der Ansprüche 9 bis 14, **dadurch gekennzeichnet, dass** mittels des Umluftsystems (9) in der Prozessebene (2) eine turbulente Mischströmung als Verdrängungsströmung ausgebildet wird, in der äußeren Umgebung (5) der Arbeitsstationseinhausung (1) ebenfalls im Wesentlichen eine turbulente Mischströmung vorherrscht oder ausgebildet wird, und an der Einbringöffnung (6) der Prozessebene (2) und an der Ausbringöffnung (7) der Prozessebene (2) mittels der Luftmesser (95) jeweils ein stationäres laminares Strömungsbild (10) ausgebildet wird.
